# FASCICULE DE BREVET EUROPEEN

(11) **EP 4 052 052 B1**
(45) Date de publication et mention de la délivrance du brevet: **18.12.2024**
(21) Numéro de dépôt: 20789603.6
(22) Date de dépôt: 13.10.2020
(51) Int. Cl.: G01R 31/08, H02H 7/26, H02H 1/00, H02H 5/10

(54) **SYSTEME DE SURVEILLANCE DE L'ETAT D'UN CABLE PAR TRANSFEROMETRIE REPARTIE**
SYSTEM ZUR ÜBERWACHUNG DES ZUSTANDES EINES KABELS DURCH VERTEILTE TRANSFEROMETRIE
SYSTEM FOR MONITORING THE STATE OF A CABLE THROUGH DISTRIBUTED TRANSFEROMETRY

(30) Priorité: 29.10.2019 FR 1912140
(43) Date de publication de la demande: 07.09.2022
(73) Titulaire: Commissariat à l'Energie Atomique et aux Energies Alternatives, 75015 Paris (FR)
(72) Inventeur: JACQUES, Marie-Bénédicte, 91191 GIF SUR YVETTE CEDEX (FR); CHASTANG, Cyril, 92190 MEUDON (FR); GIRAUD, Alain, 91400 ORSAY (FR); RAVOT, Nicolas, 91191 GIF SUR YVETTE CEDEX (FR)
(74) Mandataire: Atout PI Laplace
(86) Numéro de dépôt international: PCT/EP2020/078665
(87) Numéro de publication internationale: WO 2021/083655

(56) Documents cités:
- US-A1- 2010 315 092
- US-A1- 2014 222 356

## Description

L'invention concerne le domaine de la surveillance de l'état des câbles de grandes longueurs, par exemple des câbles sous-marins, des câbles d'énergie ou des câbles de communication. De façon plus générale, l'invention s'applique à tout câble présentant une atténuation importante pour un signal se propageant d'une extrémité à l'autre du câble.

Un objectif général de l'invention est de fournir une solution permettant d'évaluer l'état de dégradation ou de vieillissement d'un câble de très grande longueur ou présentant une forte atténuation.

Parmi les solutions connues permettant de diagnostiquer l'état de santé d'un câble, les méthodes basées sur la réflectométrie permettent de détecter l'apparition de défauts sur des câbles ou réseaux de câbles. Ces méthodes sont basées sur l'injection d'un signal de test dans le câble à analyser. Le signal est réfléchi sur la discontinuité d'impédance provoquée par le défaut puis est rétro-propagé vers le point d'injection où il est mesuré. L'analyse du signal réfléchi permet de détecter un pic d'amplitude correspondant au défaut. La signature électrique peut, par exemple, prendre la forme d'un pic d'amplitude. Certaines méthodes de réflectométrie permettent également de localiser le défaut.

Différentes méthodes de réflectométrie existent, basées sur des analyses dans le domaine temporel ou fréquentiel avec des signaux de test de natures diverses (impulsionnel, multi-porteuses ou plus complexes).

Un inconvénient des méthodes de réflectométrie connues est qu'elles ne sont pas adaptées à des câbles pour lesquels l'atténuation et la dispersion du signal sont trop importantes au-delà d'une certaine distance. L'influence de l'atténuation est d'autant plus importante qu'un test de réflectométrie nécessite un trajet aller et un trajet retour du signal, ce qui double le facteur d'atténuation.

Il existe donc un besoin pour un système d'analyse de l'état de dégradation d'un câble de très grande longueur ou de câbles très atténuants.

On connaît par ailleurs la méthode décrite dans la publication scientifique « Transferometry : a new tool for complex wired networks diagnosis, F. Auzanneau, Progress in Electromagnetics Research B, vol 70, 87-100,2016 ». Ce document décrit une méthode de détection de défauts par transférométrie pour des réseaux complexes de câbles en positionnant un capteur à chaque extrémité du réseau. La méthode proposée n'adresse pas la problématique de la surveillance de simples câbles de très grande longueur. On connaît aussi le système et le procédé de réflectométrie temporaire divulgués dans le document US 2014/222356 A1. En outre, le document US 2010/0351092 A1 divulgue des procédés et dispositifs de détermination de courants de fuites dans des réseaux de transmission.

L'invention propose une solution qui permet de surveiller la dégradation d'un câble de très grande longueur par le biais d'un système de surveillance composé de plusieurs capteurs répartis le long du câble et reliés à un organe de contrôle au moyen d'un lien de communication. L'organe de contrôle pilote les différents capteurs pour réaliser des tests sur chaque tronçon du câble en utilisant une méthode d'analyse par transférométrie.

L'invention résout les problèmes d'atténuation du signal par le biais d'un système multi-capteurs qui permet de réaliser des tests par tronçons de câble. Ainsi, le trajet du signal injecté dans le câble puis mesuré est diminué. Par ailleurs, l'invention utilise une méthode d'analyse par transférométrie qui exploite uniquement le trajet direct du signal et non pas le trajet réfléchi, ce qui permet encore de limiter l'impact de l'atténuation du signal sur l'analyse. L'invention est définie par le système de surveillance selon la revendication 1. Implémentations additionnelles sont définies par les revendications 2-12. En outre, l'invention concerne un ensemble, défini dans la revendication 13, comprenant un câble et le système de surveillance selon les revendications 1-12.

L'invention a pour objet un système de surveillance de l'état d'un câble, le système comprenant une pluralité de dispositifs de transférométrie étant chacun apte à injecter un signal de test en un point d'injection du câble et mesurer un signal se propageant dans le câble en un point de mesure du câble, les dispositifs de transférométrie étant destinés à être positionnés le long du câble à des positions prédéterminées de sorte à décomposer le câble en tronçons successifs, le système comprenant un organe de contrôle apte à communiquer avec les dispositifs de transférométrie et configuré de manière à réaliser au moins un test de transférométrie consistant à injecter un signal de test dans le câble au moyen d'un premier dispositif de transférométrie et mesurer le signal de test après sa propagation dans le câble au moyen d'un second dispositif de transférométrie différent du premier dispositif, le système comprenant en outre un organe de post-traitement apte à communiquer avec les dispositifs de transférométrie et configuré pour comparer le signal mesuré à un signal de référence pour en déduire un indicateur de dégradation du tronçon de câble disposé entre le premier dispositif de transférométrie et le second dispositif de transférométrie.

Selon un aspect particulier de l'invention, l'organe de contrôle est configuré pour commander, selon une procédure de test prédéfinie, chaque dispositif de transférométrie en activant ou désactivant l'injection d'un signal de test dans le câble au moyen dudit dispositif et en activant ou désactivant l'acquisition d'une mesure d'un signal se propageant dans le câble au moyen dudit dispositif.

Selon un aspect particulier de l'invention, la procédure de test consiste à exécuter successivement les commandes suivantes :
- Activer l'injection d'un signal de test par un premier dispositif de transférométrie situé au début d'un premier tronçon du câble,
- Activer l'acquisition d'une mesure de signal par un second dispositif de transférométrie disposé à la fin du premier tronçon,
- Après une première durée de surveillance prédéterminée, désactiver l'injection d'un signal de test par le premier dispositif, désactiver l'acquisition d'une mesure par le second dispositif,
la procédure comprend aussi la réitération des étapes précédentes; la réitération peut être réalisée après une seconde durée de temporisation ou simultanément.

Selon un aspect particulier de l'invention, la première durée de surveillance est prédéterminée en fonction de la vitesse de propagation du signal dans le câble et de la distance entre deux dispositifs de transférométrie consécutifs.

Selon un aspect particulier de l'invention, la seconde durée de temporisation est prédéterminée en fonction de la vitesse de propagation du signal dans le câble et d'un facteur d'atténuation du signal.

Selon un aspect particulier de l'invention, l'organe de contrôle est configuré pour activer simultanément plusieurs tests de transférométrie pour plusieurs tronçons du câble espacés entre eux d'une distance prédéterminée en fonction de la vitesse de propagation du signal dans le câble et du facteur d'atténuation du signal.

Selon un aspect particulier de l'invention, l'organe de contrôle est configuré pour activer simultanément plusieurs tests de transférométrie pour plusieurs tronçons du câble au moyen de signaux de tests orthogonaux entre eux.

Selon un aspect particulier de l'invention, le signal de référence correspond à une mesure réalisée par un dispositif de transférométrie à un instant précédent.

Selon un aspect particulier de l'invention, chaque dispositif de transférométrie comprend un moyen de couplage au câble pour injecter et mesurer un signal en un point du câble.

Selon un aspect particulier de l'invention, le moyen de couplage est un coupleur sans contact inductif ou capacitif.

Selon un aspect particulier de l'invention, le moyen de couplage est réalisé par plusieurs tores disposés en parallèle au voisinage d'un point du câble, chaque tore étant relié au dispositif de transférométrie par un fil de connexion formant plusieurs enroulements autour du tore.

Selon un aspect particulier de l'invention, le moyen de couplage est réalisé par un contact physique avec le câble.

Selon un aspect particulier de l'invention, l'indicateur de dégradation est proportionnel à la différence d'amplitude entre le signal de référence et le signal mesuré.

L'invention a aussi pour objet un ensemble comprenant un câble et un système de surveillance de l'état du câble selon l'invention.

D'autres caractéristiques et avantages de la présente invention apparaîtront mieux à la lecture de la description qui suit en relation aux dessins annexés suivants :
[Fig. 1] la figure 1 représente un schéma d'un système de surveillance de l'état d'un câble de grande longueur selon un mode de réalisation de l'invention,
[Fig. 2] la figure 2 représente un exemple de signaux exploités par le système selon l'invention pour analyser l'état de dégradation du câble,
[Fig. 3] la figure 3 représente un schéma d'un exemple de mise en oeuvre du système selon l'invention.

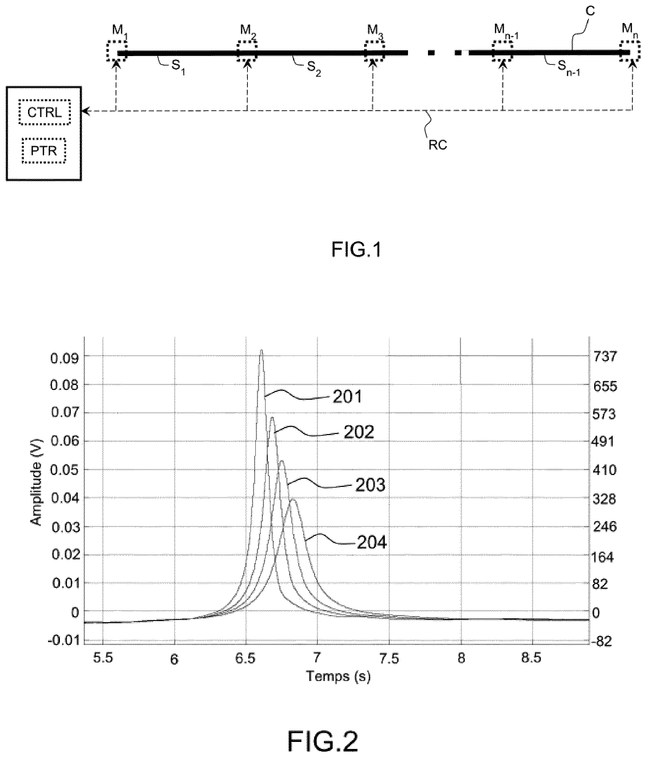

La figure 1 représente un schéma d'un système de surveillance de l'état d'un câble C selon un mode de réalisation de l'invention. Le système comprend plusieurs capteurs ou dispositifs de transférométrie M₁,M₂,M₃,...Mₙ₋₁,Mₙ disposés le long du câble C en des points choisis qui délimitent ainsi des segments de câbles S₁,S₂,..Sₙ₋₁.

Chaque dispositif de transférométrie est configuré pour assurer deux fonctions distinctes : une première fonction d'injection d'un signal de test dans le câble C et une seconde fonction de mesure d'un signal se propageant dans le câble C.

A cet effet, chaque dispositif de transférométrie comprend des moyens pour générer un signal de test, par exemple un générateur de signal ou une mémoire dans laquelle est stocké un signal numérique. Le signal peut être analogique ou numérique. Dans le cas où le signal est numérique, le dispositif comprend également un convertisseur numérique-analogique. Chaque dispositif comporte également un coupleur pour injecter le signal de test dans le câble C. Avantageusement, le coupleur a aussi pour fonction de capturer un signal se propageant dans le câble. Le coupleur peut être réalisé par contact physique ou par couplage sans contact capacitif ou inductif.

Le signal capturé est éventuellement numérisé via un convertisseur analogique numérique puis transmis, via un réseau de communication RC, vers un organe de post-traitement PTR qui est chargé d'analyser le signal.

Le type de signal de test utilisé peut être un signal impulsionnel, par exemple un créneau ou une impulsion Gaussienne, ou un signal plus complexe, par exemple un signal multi-porteuses de type OMTDR (Orthogonal Multi-Tone Time Domain Reflectometry). Le type de signal, la puissance du signal injecté dans le câble, sa fréquence ainsi que sa fréquence d'échantillonnage sont paramétrables en fonction de la nature du câble à surveiller, notamment les caractéristiques d'atténuation du câble. Ces paramètres dépendent aussi de la nature du coupleur utilisé et de la précision souhaitée pour la mesure du signal.

La distance entre deux dispositifs M₁,M₂ dépend notamment de l'atténuation et de la dispersion du câble ainsi que du niveau de précision souhaité pour les mesures. La distance entre deux dispositifs M₁,M₂ est notamment choisie de manière à limiter le niveau de l'atténuation du signal à une valeur seuil lorsque le signal parcourt le trajet entre deux dispositifs M₁,M₂ voisins. La valeur seuil est choisie, par exemple, de manière à respecter un rapport signal à bruit minimum préalablement calculé pour respecter un bilan de liaison choisi. Ainsi, le positionnement de plusieurs dispositifs le long du câble C permet de réaliser une surveillance de chaque tronçon de câble sans être dépendant du phénomène d'atténuation du signal.

Le réseau de communication RC peut être réalisé par tout moyen permettant la transmission du signal mesuré par chaque dispositif M₁,M₂,M₃,...Mₙ₋₁,Mₙ vers un organe de post-traitement PTR distant. Par exemple, le réseau de communication RC est un réseau filaire, par fibre optique ou autre câble de communication ou encore un réseau sans fil. Dans le cas d'un réseau sans fil, chaque dispositif M₁,M₂,M₃,...Mₙ₋₁,Mₙ est équipé d'un émetteur apte à transmettre des données vers l'organe de post-traitement PTR et d'un récepteur apte à recevoir des informations de contrôle émises par un organe de contrôle CTRL.

L'organe de contrôle CTRL a pour fonction de mettre en oeuvre une procédure de test en pilotant les différents dispositifs disposés le long du câble. En particulier, l'organe de contrôle CTRL transmet des commandes à chaque dispositif pour activer ou désactiver l'injection d'un signal de test dans le câble et pour activer ou désactiver une mesure d'un signal se propageant dans le câble.

L'organe de contrôle CTRL est en charge de gérer le séquencement des activations des différents dispositifs en fonction de la durée de propagation du signal.

En référence à la figure 1, on décrit un exemple de procédure de test mise en oeuvre pour surveiller successivement l'état du tronçon S₁ puis l'état du tronçon S₂ du câble C. Initialement, l'injection d'un signal et la mesure d'un signal sont désactivés sur tous les dispositifs.

De façon générale, la procédure de test consiste à mettre en oeuvre les étapes successives suivantes :
- la surveillance d'un premier tronçon S₁ est activée pendant une première durée de surveillance,
- Une seconde durée de temporisation est ensuite respectée, puis
- La surveillance d'un second tronçon S₂ est activée pendant la même première durée de surveillance,
- Les étapes sont itérées pour tous les tronçons ou un ensemble de tronçons choisis.

Sans perte de généralité, les différents tronçons S₁,S₂,Sₙ₋₁ peuvent être de même longueur ou de longueurs différentes. Dans le second cas, les durées de surveillance de chaque tronçon peuvent être adaptées aux longueurs respectives des tronçons et donc être différentes. Pour simplifier la mise en oeuvre du système, une durée de surveillance commune peut être choisie en sélectionnant la durée de surveillance la plus grande, c'est-à-dire celle qui correspond au tronçon de plus grande longueur.

Pour réaliser la surveillance du premier tronçon S₁, l'organe de contrôle CTRL transmet au premier dispositif M₁ une commande d'activation de l'injection d'un signal de test dans le câble. Le signal injecté se propage dans le câble vers le dispositif M₂. L'organe de contrôle CTRL transmet, simultanément, au deuxième dispositif M₂ une commande d'activation de mesure du signal propagé. Le signal mesuré est transmis par le dispositif M₂ vers l'organe de post-traitement PTR. Le signal injecté par le dispositif M₁ continue de se propager au-delà du dispositif M₂ vers le dispositif M₃.

Lorsque la première durée de surveillance s'est écoulée, l'organe de contrôle CTRL transmet au premier dispositif M₁ une commande de désactivation de l'injection du signal de test et au second dispositif M₂ une commande de désactivation de la mesure.

La seconde durée de temporisation est déterminée en fonction de la vitesse de propagation du signal dans le câble, de la longueur du tronçon du câble sous test et d'un facteur d'atténuation du signal dans le câble. Elle est notamment calculée de manière à prendre en compte le temps de trajet du signal injecté par le premier dispositif M₁ jusqu'à ce qu'il se propage au-delà du troisième dispositif M₃. Par ailleurs, il convient de prendre en compte aussi les éventuelles réflexions multiples de ce signal sur des discontinuités d'impédance. Ainsi, pour calculer la seconde durée de temporisation, on prend en compte une situation pire cas. Un pire cas est, par exemple, obtenu en considérant que des réflexions du signal ont lieu juste après et juste avant le troisième dispositif M₃. En considérant la puissance moyenne du signal et son facteur d'atténuation (qui dépend des caractéristiques physiques du câble), on peut calculer l'atténuation du signal au cours du temps et au fur et à mesure des réflexions multiples. Lorsque le signal atténué présente une puissance (ou une amplitude) inférieure à un seuil prédéterminé, on peut considérer que son influence est négligeable. La seconde durée de temporisation peut donc être prise égale à la durée cumulée des trajets multiples du signal jusqu'à ce que la puissance ou l'amplitude du signal devienne inférieure à un seuil prédéterminé.

De façon plus générale, la seconde durée de temporisation peut être déterminée de sorte à prendre en compte des marges suffisantes pour éviter des interférences entre les signaux émis par deux dispositifs voisins.

Lorsque la seconde durée de temporisation s'est écoulée, l'organe de contrôle CTRL active la surveillance du second tronçon S₂. Pour cela, il transmet au deuxième dispositif M₂ une commande d'activation d'injection d'un signal de test dans le câble. Il transmet également au troisième dispositif M₃ une commande d'activation d'une mesure du signal émis par le dispositif M₂ et propagé jusqu'au dispositif M₃.

De façon plus générale, l'organe de contrôle CTRL prend en compte les éventuelles interférences entre signaux injectés par différents dispositifs de sorte à les éviter. En particulier, l'organe de contrôle CTRL assure qu'à un instant donné, un dispositif assure soit la fonction d'injection du signal de test dans le câble, soit la fonction de mesure mais pas les deux en même temps.

Les différents dispositifs de transférométrie n'ont pas besoin d'être synchronisés précisément entre eux.

La procédure de test mise en oeuvre par l'organe de contrôle CTRL peut prendre différentes formes. Elle peut consister en un test successif de l'état de chaque tronçon de câble S₁,S₂...Sₙ₋₁ lorsque l'objectif visé est la surveillance de l'ensemble du câble. Alternativement, elle peut aussi consister en un test indépendant d'un tronçon de câble, par exemple pour surveiller l'évolution d'une dégradation préalablement détectée.

Dans une variante de réalisation de l'invention, l'organe de contrôle CTRL active simultanément la surveillance de deux ou plusieurs tronçons de câble lorsque la distance entre deux tronçons surveillés simultanément est suffisamment grande pour que le signal qui se propage sur cette distance soit suffisamment atténué. La distance minimale entre deux dispositifs est déterminée de sorte que l'activation simultanée de ces deux dispositifs n'engendre pas d'interférences. Pour cela, on prend en compte la vitesse de propagation du signal dans le câble, la longueur du tronçon du câble sous test, un facteur d'atténuation du signal dans le câble et les éventuelles réflexions que subit le signal.

Dans encore une autre variante de réalisation de l'invention, on utilise des signaux orthogonaux entre eux, par exemple des signaux codés au moyen d'un code de type CDMA (Code Division Multiple Access) ou « Accès multiple par répartition » en français. Dans ce cas, chaque dispositif utilise un signal différent, orthogonal à tous les autres. Ainsi, il est possible de réaliser la surveillance simultanée de tous les tronçons en même temps. Dans cette variante de réalisation, l'organe de contrôle CTRL ne gère plus le séquencement des mesures mais la répartition des signaux orthogonaux entre les différents dispositifs du système.

Les mesures réalisées sont transmises à un organe de post-traitement PTR qui réalise un test de transférométrie pour détecter une dégradation d'un tronçon de câble.

Un test de transférométrie consiste à comparer la mesure réalisée à une référence obtenue à un instant précédent, par exemple correspondant à un état neuf ou sain du câble.

La figure 2 représente, sur un diagramme, un exemple de signaux mesurés après leur propagation entre deux dispositifs M₁,M₂ voisins. Le signal injecté est un créneau temporel. Le signal 201 correspond à une référence obtenue pour un état sain ou non dégradé du câble. Les signaux 202,203,204 sont obtenus pour différents niveaux de dégradation du câble.

Un test de transférométrie consiste, par exemple, à calculer la différence entre le maximum du pic du signal obtenu respectivement pour la mesure courante et pour la référence. Comme on peut le voir sur la figure 2, plus le câble est dégradé, plus le pic de signal est atténué. Le test de transférométrie peut prendre en compte d'autres caractéristiques du signal, comme la largeur du pic à un niveau d'amplitude donné, ou d'autres critères plus complexes. La comparaison est basée en particulier sur l'atténuation ou la dispersion du signal. Dans tous les cas, un objectif du test de transférométrie est de comparer la forme des signaux obtenus à deux instants différents afin de détecter une dégradation du câble entre ces deux instants. La méthode de comparaison est par exemple basée sur une méthode des moindres carrés ou sur une corrélation entre les deux signaux afin d'évaluer les différences ou les ressemblances entre les deux mesures. La mesure de référence 201 peut aussi être obtenue par simulation à partir d'une modélisation des paramètres du câble.

Un avantage procuré par l'invention est la possibilité de fournir une information de localisation de dégradation limitée à la résolution d'un tronçon. Autrement dit, l'invention permet de localiser un tronçon dégradé.

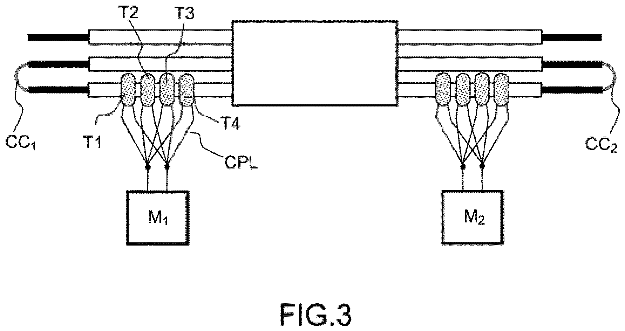

La figure 3 représente, sur un schéma, un exemple de réalisation d'un dispositif de transférométrie M₁,M₂ utilisé pour surveiller l'état d'un conducteur d'un câble triphasé comprenant trois conducteurs. Les extrémités du câble sous test sont mises en court-circuit CC₁, CC₂ avec un conducteur voisin permettant au courant de circuler entre les deux conducteurs.

Cette boucle peut être réalisée de différentes façons. Un premier exemple de réalisation consiste à relier l'âme d'un câble coaxial à son blindage via une résistance à chacune des extrémités du câble. Un second exemple de réalisation consiste à relier deux conducteurs indépendants via des court-circuits CC₁,CC₂ comme illustré sur la figure 3.

Dans l'exemple illustré à la figure 3, le couplage entre chaque dispositif M₁,M₂ et le câble est réalisé par un coupleur CPL à induction sans contact. Les coupleurs à induction sont, par exemple, réalisés par des tores de ferrite T₁,T₂,T₃,T₄ montés en parallèle au voisinage d'un point du câble. Dans l'exemple de la figure 3, le coupleur est constitué de quatre tores. Chaque tore présente plusieurs enroulements du fil de connexion qui le relie au dispositif. Le nombre de tores et le nombre d'enroulements est un paramètre qui permet d'adapter le gain du couplage et sa constance en fréquence de sorte à maitriser au mieux le signal injecté ou mesuré.

L'exemple de la figure 3 peut être généralisé à la surveillance de l'ensemble des trois conducteurs du câble en positionnant un coupleur CPL sur chaque conducteur ou à un câble simple à un seul connecteur.

Sans sortir du cadre de l'invention, le couplage entre le câble et chaque dispositif peut être réalisé par d'autres moyens de couplage sans contact ou par une connexion physique au câble. Par exemple, un couplage galvanique peut être réalisé en dénudant le câble pour le mettre en contact avec une pince métallique reliée au dispositif M₁,M₂.

Chaque dispositif de transférométrie peut être mis en oeuvre au moyen d'un processeur embarqué. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gate Array »). Le dispositif selon l'invention peut utiliser un ou plusieurs circuits électroniques dédiés ou un circuit à usage général. La technique de l'invention peut se réaliser sur une machine de calcul reprogrammable (un processeur ou un micro-contrôleur par exemple) exécutant un programme comprenant une séquence d'instructions, ou sur une machine de calcul dédiée (par exemple un ensemble de portes logiques comme un FPGA ou un ASIC, ou tout autre module matériel).

L'organe de contrôle CTRL et l'organe de post-traitement PTR peuvent être mis en oeuvre au moyen d'un ordinateur ou tout autre dispositif de calcul équivalent.

## Revendications

1. Système de surveillance de l'état d'un câble (C), le système comprenant une pluralité de dispositifs de transférométrie (M₁,M₂,M₃,...Mₙ₋₁,Mₙ) étant chacun apte à injecter un signal de test en un point d'injection du câble et mesurer un signal se propageant dans le câble en un point de mesure du câble, les dispositifs de transférométrie étant destinés à être positionnés le long du câble à des positions prédéterminées de sorte à décomposer le câble en plusieurs tronçons successifs (S₁,S₂...Sₙ₋₁) chaque tronçon étant défini par un premier dispositif de transférométrie situé au début du tronçon et un second dispositif de transférométrie disposé à la fin du tronçon, le système comprenant un organe de contrôle (CTRL) apte à communiquer avec les dispositifs de transférométrie et configuré de manière à réaliser au moins un test de transférométrie consistant à injecter un signal de test dans le câble au moyen d'un premier dispositif de transférométrie et mesurer le signal de test après sa propagation dans le câble au moyen d'un second dispositif de transférométrie différent du premier dispositif, le système comprenant en outre un organe de post-traitement (PTR) apte à communiquer avec les dispositifs de transférométrie et configuré pour comparer le signal mesuré à un signal de référence pour en déduire un indicateur de dégradation du tronçon (S₁) de câble disposé entre le premier dispositif de transférométrie (M₁) et le second dispositif de transférométrie (M₂), l'organe de contrôle (CTRL) étant configuré pour commander, selon une procédure de test prédéfinie, chaque dispositif de transférométrie en activant ou désactivant l'injection d'un signal de test dans le câble au moyen dudit dispositif et en activant ou désactivant l'acquisition d'une mesure d'un signal se propageant dans le câble au moyen dudit dispositif,
la procédure de test consistant à exécuter successivement les commandes suivantes :
- Activer l'injection d'un signal de test par un premier dispositif de transférométrie (M₁) situé au début d'un premier tronçon (S₁) du câble,
- Activer l'acquisition d'une mesure de signal par un second dispositif de transférométrie (M₂) disposé à la fin du premier tronçon (S₁),
- Après une première durée de surveillance prédéterminée, désactiver l'injection d'un signal de test par le premier dispositif (M₁), désactiver l'acquisition d'une mesure par le second dispositif (M₂),
- La procédure comprenant en outre la réitération des étapes précédentes pour au moins un autre tronçon du câble

2. Système de surveillance de l'état d'un câble selon la revendication 1 dans lequel la réitération des étapes précédentes est réalisée après une seconde durée de temporisation prédéterminée.

3. Système de surveillance de l'état d'un câble selon l'une quelconque des revendications 1 ou 2 dans lequel la première durée de surveillance est prédéterminée en fonction de la vitesse de propagation du signal dans le câble et de la distance entre deux dispositifs de transférométrie consécutifs.

4. Système de surveillance de l'état d'un câble selon la revendication 3 lorsqu'elle dépend de la revendication 2, dans lequel la seconde durée de temporisation est prédéterminée en fonction de la vitesse de propagation du signal dans le câble et d'un facteur d'atténuation du signal.

5. Système de surveillance de l'état d'un câble selon la revendication 1 dans lequel l'organe de contrôle (CTRL) est configuré pour activer simultanément la réitération des étapes précédentes pour plusieurs tronçons du câble espacés entre eux d'une distance prédéterminée en fonction de la vitesse de propagation du signal dans le câble et du facteur d'atténuation du signal.

6. Système de surveillance de l'état d'un câble selon la revendication 1 dans lequel l'organe de contrôle (CTRL) est configuré pour activer simultanément la réitération des étapes précédentes pour plusieurs tronçons du câble au moyen de signaux de tests orthogonaux entre eux.

7. Système de surveillance de l'état d'un câble selon l'une des revendications précédentes dans lequel le signal de référence correspond à une mesure réalisée par un dispositif de transférométrie à un instant précédent.

8. Système de surveillance de l'état d'un câble selon l'une des revendications précédentes dans lequel chaque dispositif de transférométrie comprend un moyen de couplage au câble pour injecter et mesurer un signal en un point du câble.

9. Système de surveillance de l'état d'un câble selon la revendication 8 dans lequel le moyen de couplage est un coupleur sans contact de type inductif ou capacitif.

10. Système de surveillance de l'état d'un câble selon la revendication 8 dans lequel le moyen de couplage (CPL) est réalisé par plusieurs tores (T₁,T₂,T₃,T₄) disposés en parallèle au voisinage d'un point du câble, chaque tore étant relié au dispositif de transférométrie par un fil de connexion formant plusieurs enroulements autour du tore.

11. Système de surveillance de l'état d'un câble selon la revendication 8 dans lequel le moyen de couplage est réalisé par un contact physique avec le câble.

12. Système de surveillance de l'état d'un câble selon l'une des revendications précédentes dans lequel l'indicateur de dégradation est proportionnel à la différence d'amplitude entre le signal de référence et le signal mesuré.

13. Ensemble comprenant un câble (C) et un système de surveillance de l'état du câble selon l'une des revendications précédentes.

## Patentansprüche

1. System zur Überwachung des Zustands eines Kabels (C), wobei das System eine Vielzahl von Transferometrievorrichtungen (M₁, M₂, M₃, ... Mₙ₋₁, Mₙ) umfasst, von denen jede ein Testsignal an einem Injektionspunkt des Kabels injizieren und ein sich im Kabel ausbreitendes Signal an einem Messpunkt des Kabels messen kann, wobei die Transferometrievorrichtungen zum Positionieren entlang des Kabels an vorbestimmten Positionen bestimmt sind, um das Kabel in mehrere aufeinanderfolgende Abschnitte (S₁, S₂, ... Sₙ₋₁) zu zerlegen, wobei jeder Abschnitt durch eine am Anfang des Abschnitts befindliche erste Transferometrievorrichtung und eine am Ende des Abschnitts befindliche zweite Transferometrievorrichtung definiert ist, wobei das System ein Steuerorgan (CTRL) umfasst, das mit den Transferometrievorrichtungen kommunizieren kann und zum Durchführen mindestens eines Transferometrietests konfiguriert ist, der darin besteht, ein Testsignal mittels einer ersten Transferometrievorrichtung in das Kabel zu injizieren und das Testsignal nach seiner Ausbreitung im Kabel mittels einer sich von der ersten Vorrichtung unterscheidenden zweiten Transferometrievorrichtung zu messen, wobei das System ferner ein Nachverarbeitungsorgan (PTR) umfasst, das mit den Transferometrievorrichtungen kommunizieren kann und zum Vergleichen des gemessenen Signals mit einem Referenzsignal konfiguriert ist, um daraus einen Indikator für die Verschlechterung des Kabelabschnitts (S₁) zwischen der ersten Transferometrievorrichtung (M₁) und der zweiten Transferometrievorrichtung (M₂) abzuleiten, wobei das Steuerorgan (CTRL) konfiguriert ist zum Steuern, gemäß einer vordefinierten Testprozedur, jeder Transferometrievorrichtung durch Aktivieren oder Deaktivieren der Injektion eines Testsignals in das Kabel mittels der Vorrichtung und durch Aktivieren oder Deaktivieren der Erfassung einer Messung eines sich in dem Kabel ausbreitenden Signals mittels der Vorrichtung,
wobei die Testprozedur darin besteht, nacheinander die folgenden Befehle auszuführen:
- Aktivieren der Injektion eines Testsignals durch eine am Anfang eines ersten Abschnitts (S₁) des Kabels befindliche erste Transferometrievorrichtung (M₁),
- Aktivieren der Erfassung einer Signalmessung durch eine am Ende des ersten Abschnitts (S₁) angeordnete zweite Transferometrievorrichtung (M₂),
- nach einer ersten vorbestimmten Überwachungszeit Deaktivieren der Injektion eines Testsignals durch die erste Vorrichtung (M₁), Deaktivieren der Erfassung einer Messung durch die zweite Vorrichtung (M₂),
- wobei die Prozedur ferner das Wiederholen der vorherigen Schritte für mindestens einen weiteren Abschnitt des Kabels umfasst.

2. System zur Überwachung des Zustands eines Kabels nach Anspruch 1, wobei die Wiederholung der vorherigen Schritte nach einer zweiten vorbestimmten Verzögerungszeit erfolgt.

3. System zur Überwachung des Zustands eines Kabels nach Anspruch 1 oder 2, wobei die erste Überwachungszeit in Abhängigkeit von der Ausbreitungsgeschwindigkeit des Signals im Kabel und dem Abstand zwischen zwei aufeinanderfolgenden Transferometrievorrichtungen vorbestimmt wird.

4. System zur Überwachung des Zustands eines Kabels nach Anspruch 3, wenn es von Anspruch 2 abhängt, wobei die zweite Verzögerungszeit in Abhängigkeit von der Ausbreitungsgeschwindigkeit des Signals im Kabel und einem Signaldämpfungsfaktor vorbestimmt wird.

5. System zur Überwachung des Zustands eines Kabels nach Anspruch 1, wobei das Steuerorgan (CTRL) zum gleichzeitigen Aktivieren der Wiederholung der vorherigen Schritte für mehrere Abschnitte des Kabels, die in einem vorbestimmten Abstand voneinander entfernt sind, in Abhängigkeit von der Ausbreitungsgeschwindigkeit des Signals im Kabel und dem Signaldämpfungsfaktor konfiguriert ist.

6. System zur Überwachung des Zustands eines Kabels nach Anspruch 1, wobei das Steuerorgan (CTRL) zum gleichzeitigen Aktivieren der Wiederholung der vorherigen Schritte für mehrere Abschnitte des Kabels mittels zueinander orthogonaler Testsignale konfiguriert ist.

7. System zur Überwachung des Zustands eines Kabels nach einem der vorhergehenden Ansprüche, wobei das Referenzsignal einer Messung entspricht, die von einer Transferometrievorrichtung zu einem vorherigen Zeitpunkt durchgeführt wurde.

8. System zur Überwachung des Zustands eines Kabels nach einem der vorhergehenden Ansprüche, wobei jede Transferometrievorrichtung ein Mittel zur Kopplung an das Kabel umfasst, um ein Signal an einem Punkt des Kabels zu injizieren und zu messen.

9. System zur Überwachung des Zustands eines Kabels nach Anspruch 8, wobei das Kopplungsmittel ein kontaktloser Koppler vom induktiven oder kapazitiven Typ ist.

10. System zur Überwachung des Zustands eines Kabels nach Anspruch 8, wobei das Kopplungsmittel (CPL) durch mehrere Tori (T₁, T₂, T₃, T₄) realisiert wird, die parallel in der Nähe eines Punktes des Kabels angeordnet sind, wobei jeder Torus mit der Transferometrievorrichtung durch einen Verbindungsdraht verbunden ist, der mehrere Wicklungen um den Torus bildet.

11. System zur Überwachung des Zustands eines Kabels nach Anspruch 8, wobei das Kopplungsmittel durch einen physischen Kontakt mit dem Kabel hergestellt wird.

12. System zur Überwachung des Zustands eines Kabels nach einem der vorhergehenden Ansprüche, wobei der Verschlechterungsindikator proportional zur Amplitudendifferenz zwischen dem Referenzsignal und dem gemessenen Signal ist.

13. Satz, der ein Kabel (C) und ein System zur Überwachung des Zustands des Kabels nach einem der vorhergehenden Ansprüche umfasst.

## Claims

1. A system for monitoring the state of a cable (C), the system comprising a plurality of transferometry devices (M₁, M₂, M₃, ... Mₙ₋₁, Mₙ), each capable of injecting a test signal at an injection point of the cable and of measuring a signal propagating through the cable at a measurement point of the cable, the transferometry devices being intended to be positioned along the cable at predetermined positions so as to divide the cable into several successive sections (S₁, S₂, ... Sₙ₋₁), wherein each section is defined by a first transferometry device located at the beginning of the section and a second transferometry device disposed at the end of the section, the system comprising a control component (CTRL) capable of communicating with the transferometry devices and configured so as to carry out at least one transferometry test involving injecting a test signal into the cable by means of a first transferometry device and measuring the test signal after it has propagated through the cable by means of a second transferometry device different from the first device, the system further comprising a post-processing component (PTR) capable of communicating with the transferometry devices and configured to compare the measured signal with a reference signal to deduce therefrom an indicator of the degradation of the cable section (S₁) disposed between the first transferometry device (M₁) and the second transferometry device (M₂), with the control component (CTRL) being configured to control, according to a predefined test procedure, each transferometry device by activating or deactivating the injection of a test signal into the cable by means of said device and by activating or deactivating the acquisition of a measurement of a signal propagating through the cable by means of said device,
wherein the test procedure involves successively executing the following commands:
- activating the injection of a test signal by a first transferometry device (M₁) located at the beginning of a first section (S₁) of the cable;
- activating the acquisition of a signal measurement by a second transferometry device (M₂) disposed at the end of the first section (S₁);
- deactivating, after a first predetermined monitoring duration, the injection of a test signal by the first device (M₁), deactivating the acquisition of a measurement by the second device (M₂);
- the procedure further comprising reiterating the preceding steps for at least one other section of the cable.

2. The system for monitoring the state of a cable according to claim 1, wherein reiterating the preceding steps is carried out after a second predetermined timing duration.

3. The system for monitoring the state of a cable according to any one of claims 1 or 2, wherein the first monitoring duration is predetermined as a function of the propagation speed of the signal through the cable and of the distance between two consecutive transferometry devices.

4. The system for monitoring the state of a cable according to claim 3 as dependent on claim 2, wherein the second timing duration is predetermined as a function of the propagation speed of the signal through the cable and of a signal attenuation factor.

5. The system for monitoring the state of a cable according to claim 1, wherein the control component (CTRL) is configured to simultaneously activate the reiteration of the preceding steps for several sections of the cable mutually spaced apart by a predetermined distance as a function of the propagation speed of the signal through the cable and of the signal attenuation factor.

6. The system for monitoring the state of a cable according to claim 1, wherein the control component (CTRL) is configured to simultaneously activate the reiteration of the preceding steps for several sections of the cable by means of test signals that are mutually orthogonal.

7. The system for monitoring the state of a cable according to any of the preceding claims, wherein the reference signal corresponds to a measurement carried out by a transferometry device at a preceding instant.

8. The system for monitoring the state of a cable according to any of the preceding claims, wherein each transferometry device comprises a coupling means for coupling to the cable for injecting and measuring a signal at a point of the cable.

9. The system for monitoring the state of a cable according to claim 8, wherein the means for coupling is a contactless coupler of the inductive or capacitive type.

10. The system for monitoring the state of a cable according to claim 8, wherein the coupling means (CPL) is implemented by several tori (T₁, T₂, T₃, T₄) arranged in parallel in the vicinity of a point of the cable, with each torus being connected to the transferometry device by a connecting wire forming several windings around the torus.

11. The system for monitoring the state of a cable according to claim 8, wherein the coupling means is implemented by physical contact with the cable.

12. The system for monitoring the state of a cable according to any of the preceding claims, wherein the degradation indicator is proportional to the difference in amplitude between the reference signal and the measured signal.

13. An assembly comprising a cable (C) and a system for monitoring the state of the cable according to any of the preceding claims.
